# EUROPEAN PATENT APPLICATION

(11) **EP 4 576 198 A1**
(43) Date of publication of application: **25.06.2025**
(21) Application number: 24220775.1
(22) Date of filing: 17.12.2024
(51) Int. Cl.: H01L 23/367, H01L 23/433, H01L 23/31, H01L 23/373

(54) **POWER MODULE, PRODUCTION METHOD THEREOF, AND POWER DEVICE**

(30) Priority: 21.12.2023 CN 202311775270
(71) Applicant: Huawei Digital Power Technologies Co., Ltd., Shenzhen, Guangdong 518043 (CN)
(72) Inventor: LIU, Qipeng, Shenzhen, 518043 (CN); WU, Fankun, Shenzhen, 518043 (CN); ZHU, Gaojie, Shenzhen, 518043 (CN); WANG, Yanbo, Shenzhen, 518043 (CN)
(74) Representative: Gill Jennings & Every LLP

(57) **Abstract**

This application relates to the power electronics technologies, and discloses a power module, a production method thereof, and a power device. The power module includes a first substrate, a second substrate, a chip, and a package body The first substrate includes a first surface and a second surface, and the first surface is configured to mount the chip. The second substrate includes a bearing surface, the bearing surface is configured to bear the first substrate, and the bearing surface is in contact with the second surface The bearing surface includes a first region and a second region, the first region is opposite to the first substrate, the second region is disposed in a ring shape around the first region, and a surface material of the second region includes copper, a copper alloy, or a copper oxide. The package body is configured to wrap the chip, the first substrate, and at least a part of the second substrate, and the package body is in contact with the second region. Because there is no other metal plating layer or organic plating layer between a surface of the second region and the package body, a high-strength connection can be implemented between the second substrate and the package body This helps improve structural reliability of the power module.

## Description

### TECHNICAL FIELD

This application relates to the power electronics technologies, and in particular, to a power module, a production method thereof, and a power device.

### BACKGROUND

A power module is a functional module obtained by combining power electronic devices based on specific functions and then molding or potting the combined power electronic devices as a whole by using a molding compound. The power module is widely used in devices such as servo motors, frequency converters, and inverters. In consideration of high heat dissipation and insulation requirements of the power module, a metal-layered ceramic substrate having significant advantages such as high temperature resistance, corrosion resistance, high mechanical strength, and deterioration resistance is usually selected as a carrier of an electronic device in the power module, and a heat dissipation substrate having high thermal conductivity is selected as a carrier of the ceramic substrate, to dissipate heat to the outside by using the heat dissipation substrate.

Currently, a material of the heat dissipation substrate in the power module is generally copper. During actual application, to prevent corrosion, a surface of the heat dissipation substrate is usually plated with a layer of nickel. However, a bonding force between the nickel layer and the molding compound is weak. When a temperature of an external environment or inside the power module changes, thermal stress causes a disconnection between the heat dissipation substrate and the molding compound due to a difference between thermal expansion coefficients of different materials. In this case, overall thermal stress inside the module is concentrated on the ceramic substrate. When stress applied to a ceramic wafer exceeds a strength threshold of the ceramic wafer, cracking occurs, leading to a failure in insulation and voltage resistance of the power module.

### SUMMARY

This application provides a power module, a production method thereof, and a power device, to improve structural strength of the power module.

According to a first aspect, this application provides a power module. The power module may include a first substrate, a second substrate, a chip, and a package body. The first substrate includes a first surface and a second surface that are disposed opposite to each other in a first direction, and the first surface may be configured to mount the chip. The second substrate includes a bearing surface, the bearing surface is configured to bear the first substrate, and the bearing surface is in contact with the second surface of the first substrate. The bearing surface includes a first region and a second region, and a projection of the first region in the first direction coincides with a projection of the second surface of the first substrate in the first direction. The second region is disposed in a ring shape around the first region, and a surface material of the second region includes copper, a copper alloy, or a copper oxide. The package body is configured to wrap the chip, the first substrate, and at least a part of the second substrate, to package the power module as a whole. Because the second region is exposed in a region that is not covered by the second surface, the second region can be in contact with the package body. In addition, because there is no other metal plating layer or organic plating layer between a surface of the second region and the package body, a bonding force between the second substrate and the package body is strong. When a temperature of an external environment or inside the power module changes, adequate connection strength can still be maintained between the second substrate and the package body under an action of thermal stress. In addition, a cracking risk of the first substrate is also reduced due to reduced thermal stress, so that structural reliability of the power module is significantly improved.

In some implementation solutions, a surface material of the first region may be the same as the surface material of the second region. In some other implementation solutions, a metal plating layer may be disposed on a surface of the first region.

In some implementation solutions, surface roughness of the second region is greater than surface roughness of the first region. The surface roughness of the second region is increased, so that connection strength between the second region and the package body can be further improved.

For example, surface roughening may be implemented for the second region through laser ablation, physical sandblasting, chemical plating, electroplating, physical sputtering, or the like.

In some implementation solutions, a ring width of the second region may be greater than or equal to 2 mm. The ring width h of the second region is designed within the foregoing size range, to ensure that the connection strength between the second substrate and the package body can resist the action of the thermal stress inside the power module, thereby reducing a risk of delamination between the second substrate and the package body.

In some implementation solutions, the bearing surface includes a groove, the groove is located in the second region, and a surface material of an inner wall of the groove includes copper, a copper alloy, or a copper oxide. The package body may be partially filled in the groove, so that the connection strength between the second substrate and the package body is improved by using concave-convex fit between the groove and the package body. In addition, because a surface of the inner wall of the groove is also made of copper, a copper alloy, or a copper oxide, it is equivalent to increasing a surface area of the second region. Therefore, this helps further improve the connection strength between the second substrate and the package body.

During specific implementation, the groove may be of a ring-shaped structure. In this way, a high-strength connection can be implemented between any position of the second region and the package body in a circumferential direction of the second region, and connection strength between different positions and the package body is relatively uniform, so that a risk of disconnecting a local region of the second substrate from the package body can be reduced.

In some implementation solutions, the bearing surface may further include a third region. The third region is disposed in a ring shape around the second region, and surface roughness of the third region is less than the surface roughness of the second region. In an implementation, a surface material of the third region may be the same as the surface material of the second region. In another implementation, a metal plating layer may be disposed on a surface of the third region.

In some implementation solutions, the second substrate includes a plurality of fins. The plurality of fins may be disposed on a side surface that is of the second substrate and that faces away from the bearing surface, and the plurality of fins may be sequentially spaced apart. The fins can effectively increase a heat dissipation area of the second substrate, thereby improving heat exchange efficiency between the second substrate and the external environment, and further helping improve heat dissipation effect of the power module.

According to a second aspect, this application further provides a production method of a power module. The production method may include the following steps:
mounting a chip on a first surface of a first substrate;
disposing the first substrate in a first region of a bearing surface of a second substrate, and causing a second surface of the first substrate to be in contact with the bearing surface, where the second surface is a surface that is of the first substrate and that is disposed opposite to the first surface in a first direction, and a projection of the first substrate in the first direction coincides with a projection of the first region in the first direction; and
wrapping the chip, the first substrate, and at least a part of the second substrate in a package body, where the package body is in contact with a second region of the bearing surface, the second region is disposed in a ring shape around the first region, and a surface material of the second region includes copper, a copper alloy, or a copper oxide.

In the power module produced by using the foregoing method, there is no other metal plating layer or organic plating layer between a surface of the second region and the package body. Because a bonding force between the package body and the copper, the copper alloy, or the copper oxide is strong, when a temperature of an external environment or inside the power module changes, adequate connection strength can still be maintained between the second substrate and the package body under an action of thermal stress. In addition, a cracking risk of the first substrate is also reduced due to reduced thermal stress, so that structural reliability of the power module is significantly improved.

In some implementation solutions, before fastening the first substrate to the first region of the bearing surface of the second substrate, the production method further includes:
performing roughening processing on the surface of the second region, to cause surface roughness of the second region to be greater than surface roughness of the first region. In this way, connection strength between the second region and the package body can be further improved, thereby helping to further improve the structural reliability of the power module.

In an implementation, the performing roughening processing on the surface of the second region specifically includes:
performing roughening processing on the surface of the second region of the bearing surface of the second substrate in a subtractive processing manner, where the subtractive processing manner includes laser ablation, chemical corrosion, physical sandblasting, or the like.

In another implementation, the performing roughening processing on the surface of the second region specifically includes:
performing roughening processing on the surface of the second region of the bearing surface of the second substrate in an additive processing manner, where the additive processing manner includes electroplating, chemical plating, physical sputtering, or the like.

In an implementation, the disposing the first substrate in a first region of a bearing surface of a second substrate specifically includes:
disposing the first substrate in the first region of the bearing surface of the second substrate in an atmosphere of formic acid or a mixture of nitrogen and hydrogen by using a flux-free solder. Because the surface roughness of the second region of the bearing surface is relatively large, in the atmosphere of formic acid or the mixture of nitrogen and hydrogen, the surface of the second region is not wet by the solder. Therefore, the solder is all concentrated in the first region. In this way, the solder may be avoided from overflowing into the second region to cause adverse impact on a subsequent packaging process.

In another implementation, when a surface material of the first region also includes copper, a copper alloy, or a copper oxide, the disposing the first substrate in a first region of a bearing surface of a second substrate specifically includes:
disposing the first substrate in the first region of the bearing surface of the second substrate by using a flux-containing solder. This manner helps enhance soldering effect between the first substrate and the second substrate, and reduce a soldering porosity rate, thereby improving soldering strength between the first substrate and the second substrate.

According to a third aspect, this application further provides a power device. The power device may include a circuit board and the power module in any implementation solution of the first aspect. The power module is electrically connected to the circuit board, so that the circuit board provides functions such as a current or voltage input, a current or voltage output, and power supply for the power module.

### BRIEF DESCRIPTION OF DRAWINGS

FIG. 1 is a diagram of a structure of a photovoltaic system according to an embodiment of this application;
FIG. 2 is a diagram of a structure of a power device according to an embodiment of this application;
FIG. 3 is a diagram of a partial structure of a power module according to an embodiment of this application;
FIG. 4 is a diagram of a partial structure of a power module according to an embodiment of this application;
FIG. 5 is a top view of a second substrate according to an embodiment of this application;
FIG. 6 is a top view of another second substrate according to an embodiment of this application;
FIG. 7 is a side view of a second substrate according to an embodiment of this application;
FIG. 8 is a side view of another second substrate according to an embodiment of this application;
FIG. 9 is a flowchart of a production method of a power module according to an embodiment of this application; and
FIG. 10 is a flowchart of another production method of a power module according to an embodiment of this application.

### Reference numerals:

1000: power device; 100: housing; 200: circuit board; 300: power device; 310: first substrate; 310a: first surface;
310b: second surface; 311: ceramic wafer; 312: first metal layer; 313: second metal layer; 320: second substrate; 320a: bearing surface;
321: first region; 322: second region; 323: third region; 324: groove; 325: fin; 330: chip; 340: package body;
350: pin; 360: solder.

### DESCRIPTION OF EMBODIMENTS

To make the objectives, technical solutions, and advantages of this application clearer, the following further describes embodiments of this application in detail with reference to the accompanying drawings. However, example implementations can be implemented in a plurality of forms, and should not be construed as being limited to the implementations described herein. Identical reference numerals in the accompanying drawings denote identical or similar structures. Therefore, repeated descriptions thereof are omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate a relative position relationship and do not represent an actual scale.

It should be noted that specific details are set forth in the following descriptions for ease of understanding this application. However, embodiments of this application can be implemented in a plurality of manners different from those described herein, and a person skilled in the art can perform similar promotion without departing from the connotation of embodiments of this application. Therefore, this application is not limited to the specific implementations disclosed below.

A power device is widely applied to a scenario such as a photovoltaic system, an energy storage system, or a power assembly system of a new energy vehicle, and is configured to perform power conversion on a current or a voltage in the application system. The power device may include an inverter or a micro inverter in a photovoltaic system, a converter in an energy storage system, a motor controller in a power assembly of a new energy vehicle, or the like.

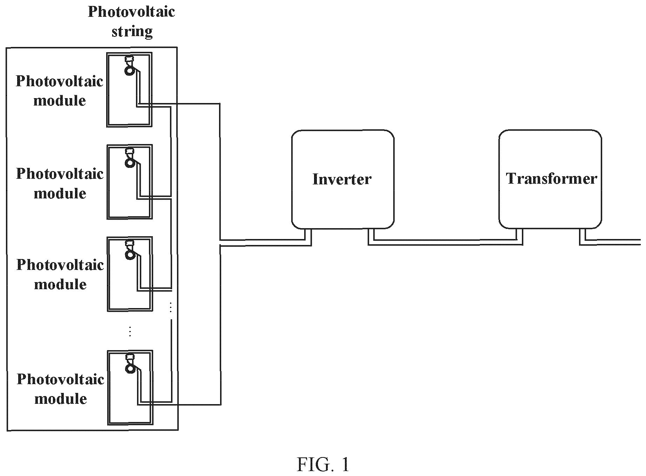

A photovoltaic system is used as an example. FIG. 1 is a diagram of a structure of a photovoltaic system according to an embodiment of this application. The photovoltaic system includes one or more photovoltaic strings, an inverter, and a transformer. The photovoltaic string may include a plurality of photovoltaic modules connected in series. The photovoltaic module is a direct current power supply including solar cells that are connected in series or in parallel and then are packaged, and is configured to convert light energy into electrical energy. The inverter is a direct current-alternating current power device, and may be configured to: convert a direct current output by the photovoltaic string into an alternating current and output the alternating current to the transformer. The transformer is configured to: transform the alternating current output by the inverter and then feed the alternating current into an alternating current power grid, to implement a grid connection of the photovoltaic system.

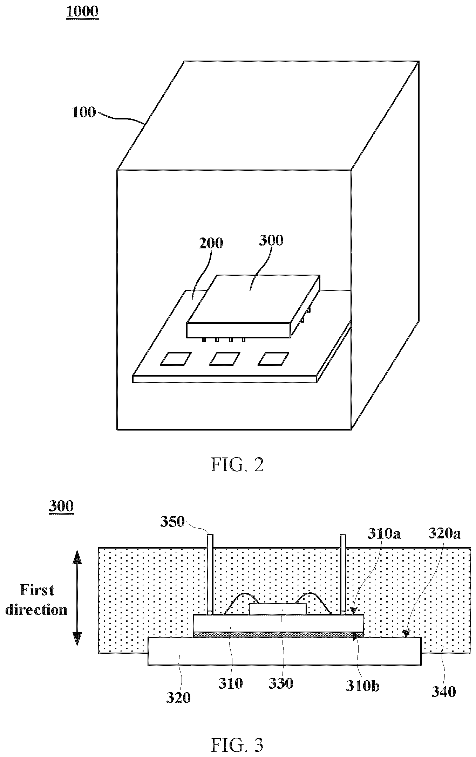

FIG. 2 is a diagram of a structure of a power device 1000 according to an embodiment of this application. The power device may be the inverter in the photovoltaic system shown in FIG. 1, or may be another type of power device. This is not limited in this application. As shown in FIG. 2, the power device 1000 may include a housing 100, and a circuit board 200 and a power module 300 that are accommodated in the housing 100. The power module 300 is electrically connected to the circuit board 200. The circuit board 200 may be a printed circuit board (PCB), a flexible printed circuit (FPC), a rigid-flex circuit board, or the like. The power module 300 is a core component for the power device 1000 to implement a power conversion function. The power module 300 may include a plurality of ports, such as input positive and negative ports, output positive and negative ports, and power supply positive and negative ports. These ports are separately electrically connected to the circuit board 200 by using pins, so that the circuit board 200 provides functions such as a current or voltage input, a current or voltage output, and power supply for the power module 300.

The power module 300 may include various electronic devices such as a chip, an inductor, a resistor, and a capacitor. These electronic devices are combined and connected based on specific functions, and then packaged as a whole by using a molding compound. The packaging material can protect a power device from being affected by an external environment (such as water vapor, a temperature, and dust and impurities), and can implement complex functions such as heat conduction, insulation, moisture resistance, voltage resistance, and support.

In consideration of high heat dissipation and insulation requirements of the power module 300, a ceramic substrate having significant advantages such as high temperature resistance, corrosion resistance, high mechanical strength, and deterioration resistance is usually selected as a carrier of an electronic device in the power module 300. Because a ceramic material itself does not have conductivity, to implement an electrical connection between the power module and the outside, metallization process wiring needs to be performed on a surface of a ceramic wafer formed by the ceramic material, and a metal-layered ceramic substrate made in this way can reliably implement thermal and electrical separation. Moreover, a heat dissipation substrate is usually further disposed in the power module 300, and the heat dissipation substrate, as a carrier of the ceramic substrate, may be carried on a side that is of the ceramic substrate and that faces away from the power device.

The heat dissipation substrate is a core heat dissipation functional structure and channel of the power module 300, and therefore needs to have good heat conduction performance. Currently, a material of the heat dissipation substrate in the power module 300 is generally copper. During actual application, to prevent the heat dissipation substrate from being corroded and to improve appearance aesthetics of the heat dissipation substrate, a surface of the heat dissipation substrate is usually plated with a layer of nickel. However, a bonding force between the plating layer nickel and the molding compound is weak. When a temperature of an external environment or inside the power module 300 changes, thermal stress is generated between different materials due to a mismatch in thermal expansion coefficients of the different materials in the power module 300. The thermal stress causes a disconnection between the heat dissipation substrate and the molding compound, and causes delamination in an internal structure of the power module 300. In this case, overall thermal stress inside the module is concentrated on the ceramic substrate. When stress applied to the ceramic wafer exceeds a strength threshold of the ceramic wafer, cracking occurs, leading to a failure in insulation and voltage resistance of the power module 300.

In view of this, embodiments of this application provide the power module 300 and the power device 1000 in which the power module 300 is used. There is a strong bonding force between the heat dissipation substrate of the power module 300 and the molding compound, so that a risk of the disconnection between the heat dissipation substrate and the packaging material can be reduced. In addition, the thermal stress applied to the ceramic substrate can be reduced, and a risk of cracking of the ceramic substrate can be reduced. This can improve structural strength of the power module 300 and reliability of the power device 1000 in which the power module 300 is used. The following specifically describes the power module 300 and the power device 1000 provided in embodiments of this application with reference to the accompanying drawings.

FIG. 3 is a diagram of a partial structure of the power module 300 according to an embodiment of this application. As shown in FIG. 3, in this embodiment of this application, the power module 300 may include a first substrate 310, a second substrate 320, a chip 330, and a package body 340. The first substrate 310 includes a first surface 310a and a second surface 31 0b. The first surface 310a and the second surface 310b are disposed opposite to each other in a first direction. The first direction may be understood as a thickness direction of the first substrate 310. The first surface 310a of the first substrate 310 may be configured to mount the chip 330. The second substrate 320 includes a bearing surface 320a. The bearing surface 320a may be configured to bear the first substrate 310, and the bearing surface 320a is in contact with the second surface 310b of the first substrate 310. That is, the second substrate 320 is borne on a side that is of the first substrate 310 and that faces away from the chip 330. The chip 330, the first substrate 310, and the second substrate 320 are sequentially arranged in the first direction. Heat generated when the chip 330 works may be transferred to the second substrate 320 through the first substrate 310, and dissipated to the outside through the second substrate 320, thereby implementing heat dissipation for the chip 330. The package body 340 may be configured to wrap the chip 330, the first substrate 310, and at least a part of the second substrate 320, to package the power module 300 as a whole. For example, the package body 340 may expose a side surface that is of the second substrate 320 and that faces away from the first substrate 310, to dissipate heat to the outside by using the side surface of the second substrate 320.

In some embodiments, the chip 330 may include an insulated gate bipolar transistor (IGBT), a metal-oxide-semiconductor field-effect transistor (MOSFET), a power transistor, or the like. There may be one or more chips 330. The one or more chips 330 and another electronic device of the power module 300 constitute a power conversion circuit. The power module 300 implements a direct current-alternating current power conversion function, a direct current-direct current power conversion function, or the like by using the power conversion circuit. Based on this, the power module 300 provided in this embodiment of this application may be used in a power device such as an inverter, a micro inverter, a converter, or a motor controller.

In some embodiments, the power module 300 further includes a plurality of pins 350, and at least a part of each pin 350 is wrapped in the package body 340. In an implementation, the first surface 310a of the first substrate 310 includes a plurality of pads, and one end of each pin 350 is soldered to a corresponding pad, so that each pin 350 is fastened to the first surface 310a and is electrically connected to the first surface 310a. The other end of each pin 350 is exposed outside the package body 340, so that each pin 350 can be electrically connected to an external device, thereby implementing an electrical connection between the power module 300 and the external device. Herein, the external device may be a circuit board of a power device in which the power module 300 is used.

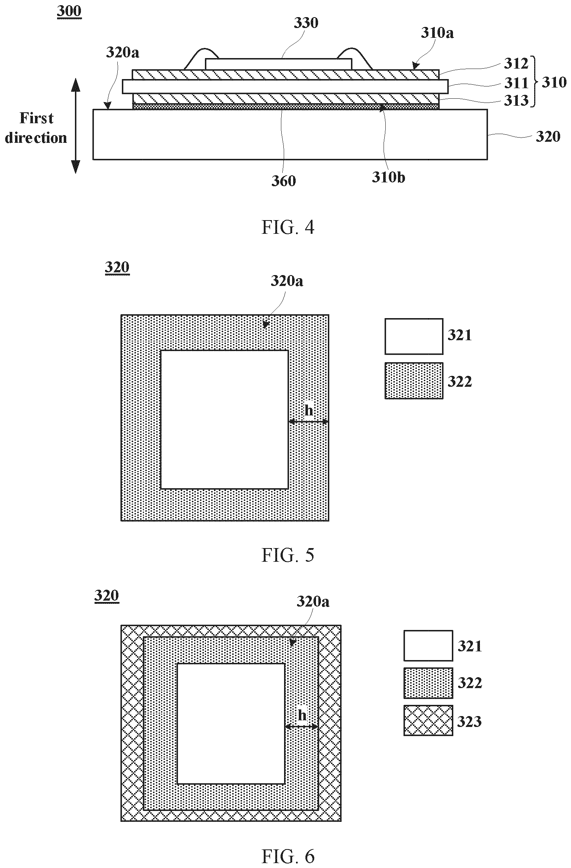

FIG. 4 is a diagram of a partial structure of the power module 300 according to an embodiment of this application. As shown in FIG. 4, in this embodiment of this application, the first substrate 310 may be a ceramic substrate, the first substrate 310 includes a ceramic wafer 311 and two metal layers, and the two metal layers are respectively fastened to two side surfaces that are of the ceramic wafer 311 and that are disposed opposite to each other. For ease of description, in this embodiment, the metal layers fastened to the two side surfaces of the ceramic wafer 311 are respectively referred to as a first metal layer 312 and a second metal layer 313, where a side surface that is of the first metal layer 312 and that faces away from the ceramic wafer 311 may be formed as the first surface 310a of the first substrate 310, and a side surface that is of the second metal layer 313 and that faces away from the ceramic wafer 311 may be formed as the second surface 310b of the first substrate 310. In addition to being configured to mount the chip 330, the first surface 310a of the first substrate 310 may be further configured to mount electronic devices such as an inductor, a resistor, and a capacitor. The chip 330 and these electronic devices may be fastened to the first surface 310a by using a soldering process. The chip 330 may be electrically connected to the first metal layer 312 by using a wire bonding (WB) process, a clip soldering process, or the like. The second surface 310b of the first substrate 310 may be fastened to the bearing surface of the second substrate 320 by soldering with a solder 360. In the soldering process between the electronic devices and the first substrate 310 and the soldering process between the first substrate 310 and the second substrate 320, the used solder includes but is not limited to a lead solder, a lead-free solder, sintered silver, sintered copper, and the like.

In an embodiment, the ceramic wafer 311 may be prepared by using a low-cost material such as aluminum oxide or aluminum nitride, to reduce overall costs of the power module 300. The first metal layer 312 and the second metal layer 313 may be copper layers, and the first substrate 310 may be a direct bonded copper (DBC) ceramic substrate, or may be an active metal brazing (AMB) ceramic substrate. In another embodiment, the first metal layer 312 and the second metal layer 313 may alternatively be aluminum layers, and the first substrate 310 is a direct bonded aluminum (DBA) ceramic substrate.

FIG. 5 is a top view of the second substrate 320 according to an embodiment of this application. As shown in FIG. 3 and FIG. 5, in this embodiment of this application, a projection of the first substrate 310 in the first direction is within a range of a projection of the bearing surface 320a in the first direction. Alternatively, it may be understood that an edge of the second substrate 320 exceeds an edge of the first substrate 310, to improve heat dissipation performance of the power module 300 by increasing a size of the second substrate 320. For example, the second substrate 320 may be made of copper or a copper alloy.

In this embodiment, the bearing surface 320a of the second substrate 320 includes a first region 321 and a second region 322. A contour of the first region 321 is consistent with an edge contour of the second surface 310b of the first substrate 310. A projection of the second surface 310b in the first direction coincides with a projection of the first region 321 in the first direction. That is, the second surface 310b may cover the first region 321, and the second region 322 is exposed in a region that is of the bearing surface and that is not covered by the second surface 31 0b. It should be noted that the coincidence defined in this embodiment of this application is not limited to a complete coincidence relationship, a non-complete coincidence relationship caused by factors such as a design tolerance and an assembly tolerance is allowed, and a small-range error is allowed. The second region 322 is disposed around the first region 321. It is easy to understand that the second region 322 is of a ring-shaped structure, and the second region 322 is exposed in the region that is not covered by the second surface 310b. Therefore, the package body 340 can be in contact with the second region 322.

During specific implementation, a surface material of the second region 322 includes copper, a copper alloy, or a copper oxide. That is, there is no other metal plating layer or organic plating layer between a surface of the second region 322 and the package body 340. In comparison with these plating layers, there is a relatively strong bonding force between the package body 340 and the copper, the copper alloy, or the copper oxide. Therefore, when the temperature of the external environment or inside the power module 300 changes, adequate connection strength can still be maintained between the second substrate 320 and the package body 340 under the action of the thermal stress. In addition, the cracking risk is also reduced due to the reduced thermal stress on the first substrate 310, so that structural reliability of the power module 300 is significantly improved.

Moreover, a surface material of the first region 321 is not limited. For example, in an implementation, the surface material of the first region 321 may be the same as the surface material of the second region 322. In another implementation, a metal plating layer may be disposed on a surface of the first region 321.

In some embodiments, the surface of the second region 322 may be a relatively rough surface. For example, surface roughness of the second region 322 is greater than surface roughness of the first region 321. The surface roughness of the second region 322 is increased, so that connection strength between the second region 322 and the package body 340 can be further improved, and therefore the structural reliability of the power module 300 can be further improved. For example, in this embodiment, roughening processing may be performed on the surface of the second region 322 through laser ablation, physical sandblasting, chemical plating, electroplating, physical sputtering, or the like.

In some embodiments, a ring width h of the second region 322 may be greater than or equal to 2 mm. It should be noted that the ring width h of the second region 322 may be understood as a width between an inner ring of the second region 322 and an outer ring of the second region 322 in an arrangement direction of the first region 321 and the second region 322. The ring width h of the second region 322 is designed within the foregoing size range, to ensure that the connection strength between the second substrate 320 and the package body 340 can resist the action of thermal stress inside the power module 300, thereby reducing a risk of delamination between the second substrate 320 and the package body 340.

FIG. 6 is a top view of another second substrate 320 according to an embodiment of this application. As shown in FIG. 3 and FIG. 6, in this embodiment of this application, the bearing surface 320a of the second substrate 320 further includes a third region 323, and the third region 323 may be disposed in a ring shape around the second region 322. That is, the first region 321, the second region 322, and the third region 323 are sequentially arranged from inside to outside. A surface material of the third region 323 is not limited. For example, in an implementation, a surface material of the third region 323 may be the same as a surface material of the second region 322. In another implementation, a metal plating layer may be disposed on a surface of the third region 323. Moreover, surface roughness of the third region 323 may be less than the surface roughness of the second region 322.

In an implementation, an outer ring of the third region 323 extends to an edge of the bearing surface 320a. That is, the third region 323 is an outermost ring region of the bearing surface 320a. A ring width of the third region 323 may be determined based on parameters such as an area of the bearing surface, an area of the first region 321, and the ring width of the second region 322. This is not limited in this application.

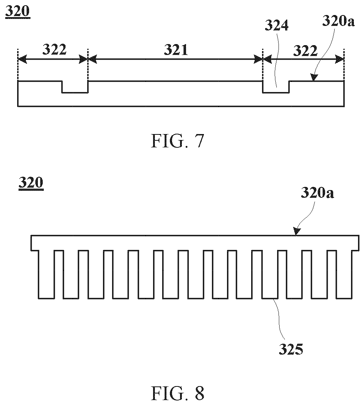

FIG. 7 is a side view of the second substrate 320 according to an embodiment of this application. As shown in FIG. 3 and FIG. 7, in this embodiment of this application, the bearing surface 320a of the second substrate 320 includes a groove 324, and the groove 324 may be specifically located in the second region 322. Therefore, a surface material of an inner wall of the groove 324 (including a side wall and a bottom wall of the groove 324) may also be copper, a copper alloy, or a copper oxide. When the package body 340 is formed, the package body 340 may be filled in the groove 324. In this way, the connection strength between the second substrate 320 and the package body 340 may be improved by using a structural feature of the groove 324. In addition, because a surface of the inner wall of the groove 324 is also made of copper, a copper alloy, or a copper oxide, it is equivalent to increasing a surface area of the second region 322. Therefore, this helps further improve the connection strength between the second substrate 320 and the package body 340.

For example, the groove 324 may be designed to be of a ring-shaped structure. In this way, a high-strength connection can be implemented between any position of the second region 322 and the package body 340 in a circumferential direction of the second region 322, and connection strength between different positions and the package body 340 is relatively uniform, so that a risk of disconnecting a local region of the second substrate 320 from the package body 340 can be reduced.

It should be noted that, when the bearing surface 320a of the second substrate 320 includes the third region, the groove 324 may alternatively be provided on the bearing surface 320a, and the groove 324 may also be located in the second region 322. Details are not described herein again.

FIG. 8 is a side view of another second substrate 320 according to an embodiment of this application. As shown in FIG. 3 and FIG. 8, in this embodiment of this application, the second substrate 320 includes a plurality of fins 325. The plurality of fins 325 may be disposed on a side surface that is of the second substrate 320 and that faces away from the bearing surface 320a. That is, the plurality of fins 325 may be disposed on a side surface that is of the second substrate 320 and that is exposed outside the package body 340. The plurality of fins 325 may be sequentially spaced apart. The fins 325 can effectively increase a heat dissipation area of the second substrate 320, thereby improving heat exchange efficiency between the second substrate 320 and the external environment, and helping improve heat dissipation effect of the power module 300.

Certainly, in some other embodiments, the power module 300 may further include a heat sink. In this case, the second substrate 320 may not need to be provided with the fins 325, the heat sink is in contact with the side surface that is of the second substrate 320 and that is exposed outside the package body 340, and the heat transferred by the first substrate 310 to the second substrate 320 may be further transferred by the second substrate 320 to the heat sink, so that heat dissipation of the power module 300 is implemented through the heat sink. The second substrate 320 may be fastened to the heat sink in a manner of soldering, sintering, or the like. For example, the heat sink may be a liquid cooling heat sink or an air cooling heat sink.

An embodiment of this application further provides a production method of a power module. The production method includes the following steps:
mounting a chip on a first surface of a first substrate;
disposing the first substrate in a first region of a bearing surface of a second substrate, and causing a second surface of the first substrate to be in contact with the bearing surface, where the second surface is a surface that is of the first substrate and that is disposed opposite to the first surface in a first direction, and a projection of the first substrate in the first direction coincides with a projection of the first region in the first direction; and
wrapping the chip, the first substrate, and at least a part of the second substrate in a package body, where the package body is in contact with a second region of the bearing surface, the second region is disposed in a ring shape around the first region, and a surface material of the second region includes copper, a copper alloy, or a copper oxide.

In the power module produced by using the foregoing method, there is no other metal plating layer or organic plating layer between a surface of the second region and the package body. Because a bonding force between the package body and the copper, the copper alloy, or the copper oxide is strong, when a temperature of an external environment or inside the power module changes, adequate connection strength can still be maintained between the second substrate and the package body under an action of thermal stress. In addition, a cracking risk of the first substrate is also reduced due to reduced thermal stress, so that structural reliability of the power module is significantly improved.

In some embodiments, before fastening the first substrate to the first region of the bearing surface of the second substrate, the production method further includes:
performing roughening processing on the surface of the second region, to cause surface roughness of the second region to be greater than surface roughness of the first region. In this way, connection strength between the second region and the package body can be further improved, thereby helping to further improve the structural reliability of the power module.

The roughening processing may be performed on the surface of the second region in a plurality of manners. The following uses two roughening processing manners as an example to describe in detail two different production methods of the power module.

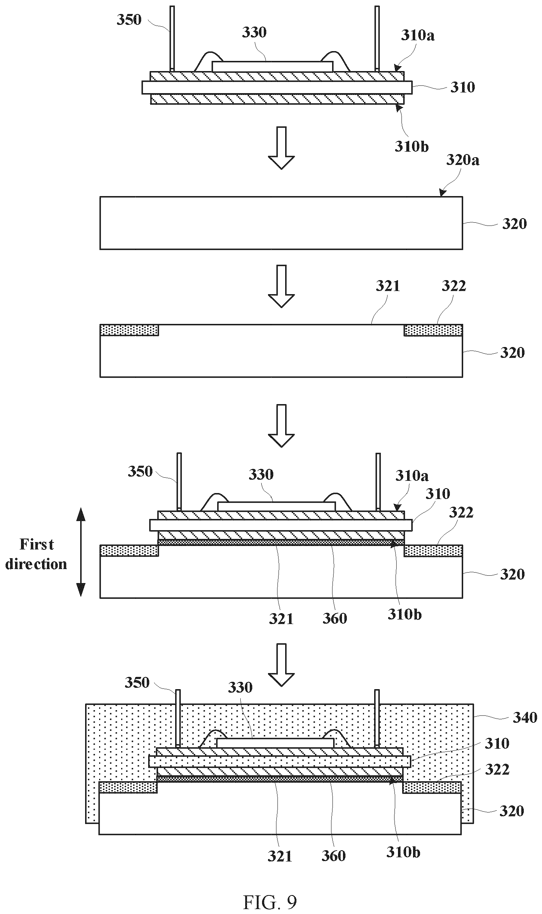

First, as shown in FIG. 9, FIG. 9 is a flowchart of a production method of the power module according to an embodiment of this application. The production method includes the following steps.

Step 1: Mount the chip 330 on the first surface 310a of the first substrate 310. The first substrate 310 includes but is not limited to a ceramic substrate of a type such as DBC, AMB, or DBA. The chip 330 may be fastened to the first surface 310a by soldering, and is electrically connected to the first substrate 310 by using a wire bonding process, a clip soldering process, or the like. Moreover, in addition to the chip 330, electronic devices such as an inductor, a resistor, a capacitor, and the pin 350 may be further mounted on the first surface of the first substrate. These electronic devices and the chip 330 may be fastened to the first surface by using a reflow soldering process.

Step 2: Perform roughening processing on the surface of the second region 322 of the bearing surface 320a of the second substrate 320 in a subtractive processing manner, to cause the surface roughness of the second region 322 to be greater than the surface roughness of the first region 321. The subtractive processing manner includes laser ablation, chemical corrosion, physical sandblasting, or the like. The second substrate 320 may be made of copper or a copper alloy. The surface material of the second region 322 obtained after the roughening processing includes copper, a copper alloy, or a copper oxide.

Step 3: Dispose the first substrate 310 in the first region 321 of the bearing surface 320a of the second substrate 320, and cause the second surface 310b of the first substrate 310 to be in contact with the bearing surface 320a. The first region 321 of the bearing surface 320a is located on an inner side of the second region 322, and the second region 322 is disposed around the first region 321. The second surface 310b is a surface that is of the first substrate 310 and that is disposed opposite to the first surface 310a in the first direction, and the projection of the second surface 310b in the first direction coincides with the projection of the first region 321 in the first direction.

It should be noted that in some implementations, step 1 and step 3 may be exchanged with each other. In other words, the first substrate 310 and the second substrate 320 may be first assembled, and then the electronic devices such as the chip 330 are mounted on the first substrate 310. This is not specifically limited in this application.

In step 3, that the first substrate 310 is disposed in the first region 321 of the bearing surface 320a of the second substrate 320 may be implemented in two manners. In one manner, the first substrate 310 is disposed in the first region 321 of the bearing surface 320a of the second substrate 320 in an atmosphere of formic acid or a mixture of nitrogen and hydrogen by using the flux-free solder 360. Because the surface roughness of the second region 322 of the bearing surface 320a is relatively large, in the atmosphere of formic acid or the mixture of nitrogen and hydrogen, the surface of the second region 322 is not wet by the solder. Therefore, the solder 360 is all concentrated in the first region 321. In this way, local soldering between the first substrate 310 and the first region 321 of the bearing surface 320a may be implemented, and the solder 360 may be prevented from overflowing into the second region 322 to cause adverse impact on a subsequent packaging process. In another manner, when a surface material of the first region 321 is also copper, a copper alloy, or a copper oxide, the first substrate 310 is disposed in the first region 321 of the bearing surface 320a of the second substrate 320 by using the flux-containing solder 360. This manner helps enhance soldering effect between the first substrate 310 and the second substrate 320, and reduce a soldering porosity rate, thereby improving soldering strength between the first substrate 310 and the second substrate 320.

Step 4: Wrap the chip 330, the first substrate 310, and at least a part of the second substrate 320 in the package body 340, where the package body 340 is in contact with the second region 322 of the bearing surface 320a. Because there is no other metal plating layer or organic plating layer between the surface of the second region 322 and the package body 340, a high-strength connection can be implemented between the second substrate 320 and the package body 340. This may improve the structural reliability of the power module.

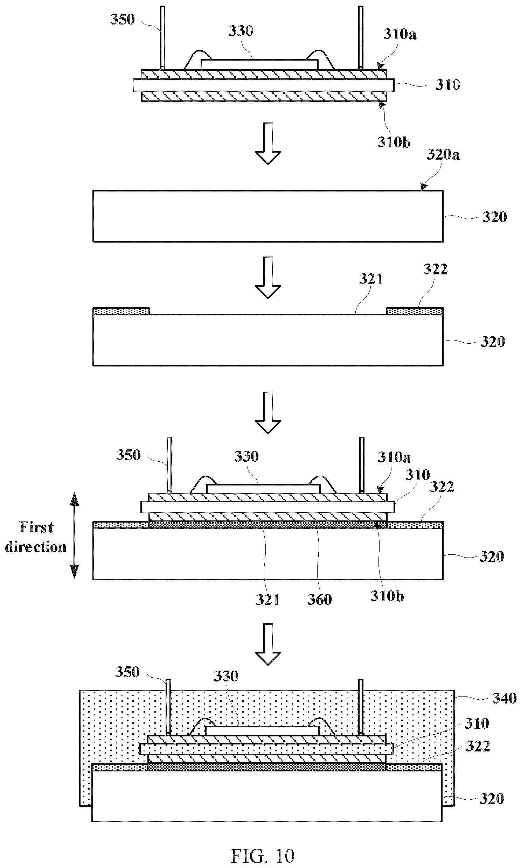

First, as shown in FIG. 10, FIG. 10 is a flowchart of another production method of the power module according to an embodiment of this application. The production method includes the following steps.

Step 1: Mount the chip 330 on the first surface 310a of the first substrate 310. The first substrate 310 includes but is not limited to a ceramic substrate of a type such as DBC, AMB, or DBA. The chip 330 may be fastened to the first surface 310a by soldering, and is electrically connected to the first substrate 310 by using a wire bonding process, a clip soldering process, or the like. In addition to the chip, electronic devices such as an inductor, a resistor, a capacitor, and the pin 350 may be further mounted on the first surface 310a of the first substrate 310. These electronic devices and the chip 330 may be fastened to the first surface 310a by using a reflow soldering process.

Step 2: Perform roughening processing on the surface of the second region 322 of the bearing surface 320a of the second substrate 320 in an additive processing manner, to cause the surface roughness of the second region 322 to be greater than the surface roughness of the first region 321. The additive processing manner includes electroplating, chemical plating, physical sputtering, or the like. The second substrate 320 may be made of copper or a copper alloy. The surface material of the second region 322 obtained after the roughening processing includes copper, a copper alloy, or a copper oxide.

Step 3: Dispose the first substrate 310 in the first region 321 of the bearing surface 320a of the second substrate 320, and cause the second surface 310b of the first substrate 310 to be in contact with the bearing surface. The first region 321 of the bearing surface 320a is located on an inner side of the second region 322, and the second region 322 is disposed around the first region 321. The second surface 310b is a surface that is of the first substrate 310 and that is disposed opposite to the first surface 310a in the first direction, and the projection of the second surface 310b in the first direction coincides with the projection of the first region 321 in the first direction.

Similar to the foregoing embodiment, step 1 and step 3 in this embodiment may also be exchanged with each other. Moreover, that the first substrate 310 is disposed in the first region 321 of the bearing surface 320a of the second substrate 320 may also be implemented with reference to the two manners in the foregoing embodiment. Details are not described herein again.

Step 4: Wrap the chip 330, the first substrate 310, and at least a part of the second substrate 320 in the package body 340, where the package body 340 is in contact with the second region 322 of the bearing surface 320a. Because there is no other metal plating layer or organic plating layer between the surface of the second region 322 and the package body 340, a high-strength connection can be implemented between the second substrate 320 and the package body 340. This may improve the structural reliability of the power module.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising a first substrate, a second substrate, a chip, and a package body, wherein
the first substrate comprises a first surface and a second surface that are disposed opposite to each other in a first direction, and the first surface is configured to mount the chip;
the second substrate comprises a bearing surface, wherein the bearing surface is configured to bear the first substrate, and the bearing surface is in contact with the second surface; and the bearing surface comprises a first region and a second region, a projection of the first region in the first direction coincides with a projection of the second surface in the first direction, the second region is disposed in a ring shape around the first region, and a surface material of the second region comprises copper, a copper alloy, or a copper oxide; and
the package body is configured to wrap the chip, the first substrate, and at least a part of the second substrate, and the package body is in contact with the second region.

2. The power module according to claim 1, wherein surface roughness of the second region is greater than surface roughness of the first region.

3. The power module according to claim 1 or 2, wherein a ring width of the second region is greater than or equal to 2 mm.

4. The power module according to any one of claims 1 to 3, wherein the bearing surface comprises a groove, the groove is located in the second region, and a surface material of an inner wall of the groove comprises copper, a copper alloy, or a copper oxide.

5. The power module according to claim 4, wherein the groove is of a ring-shaped structure.

6. The power module according to any one of claims 1 to 5, wherein the bearing surface comprises a third region, the third region is disposed in a ring shape around the second region, and surface roughness of the third region is less than the surface roughness of the second region.

7. The power module according to any one of claims 1 to 6, wherein the second substrate comprises a plurality of fins, the plurality of fins are disposed on a side that is of the second substrate and that faces away from the bearing surface, and the plurality of fins are sequentially spaced apart.

8. A production method of a power module, comprising:
mounting a chip on a first surface of a first substrate;
disposing the first substrate in a first region of a bearing surface of a second substrate, and causing a second surface of the first substrate to be in contact with the bearing surface, wherein the second surface is a surface that is of the first substrate and that is disposed opposite to the first surface in a first direction, and a projection of the second surface in the first direction coincides with a projection of the first region in the first direction; and
wrapping the chip, the first substrate, and at least a part of the second substrate in a package body, wherein the package body is in contact with a second region of the bearing surface, the second region is disposed in a ring shape around the first region, and a surface material of the second region comprises copper, a copper alloy, or a copper oxide.

9. The production method according to claim 8, wherein before fastening the first substrate to the first region of the bearing surface of the second substrate, the production method further comprises:
performing roughening processing on a surface of the second region, to cause surface roughness of the second region to be greater than surface roughness of the first region.

10. The production method according to claim 9, wherein the performing roughening processing on a surface of the second region specifically comprises:
performing roughening processing on the surface of the second region in a subtractive processing manner, wherein the subtractive processing manner comprises laser ablation, chemical corrosion, or physical sandblasting.

11. The production method according to claim 9, wherein the performing roughening processing on a surface of the second region specifically comprises:
performing roughening processing on the surface of the second region in an additive processing manner, wherein the additive processing manner comprises electroplating, chemical plating, or physical sputtering.

12. The production method according to any one of claims 9 to 11, wherein the disposing the first substrate in a first region of a bearing surface of a second substrate specifically comprises:
disposing the first substrate in the first region of the bearing surface of the second substrate in an atmosphere of formic acid or a mixture of nitrogen and hydrogen by using a flux-free solder.

13. The production method according to any one of claims 9 to 11, wherein a surface material of the first region comprises copper, a copper alloy, or a copper oxide, and the disposing the first substrate in a first region of a bearing surface of a second substrate specifically comprises:
disposing the first substrate in the first region of the bearing surface of the second substrate by using a flux-containing solder.

14. A power device, comprising a circuit board and the power module according to any one of claims 1 to 7, wherein the power module is electrically connected to the circuit board.
